(19) Europäisches Patentamt
European Patent Office
Office européen des brevets

(11) EP 2 168 908 A1

(12) EUROPEAN PATENT APPLICATION

(43) Date of publication:
31.03.2010 Bulletin 2010/13

(51) Int Cl.:
$B81B\ 3/00$ (2006.01)

(21) Application number: 08305626.7

(22) Date of filing: 30.09.2008

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(71) Applicant: Alcatel Lucent
75008 Paris (FR)

(72) Inventors:
• Gasparyan, Arman
GILLETTE, NJ 07933 (US)

• Simon, Maria Elina
NEW PROVIDENCE, NJ 07974 (US)
• Gates, John
NEW PROVIDENCE, NJ 07974 (US)

(74) Representative: Shamsaei Far, Hassan
Alcatel Lucent
Intellectual Property & Standards
54 rue La Boétie
75008 Paris (FR)

(54) **Micromechanical thermal actuator**

(57) The present invention provides a microelectromechanical element comprising a cold beam and at least a first beam pair comprising a first beam member and a second beam member, the beam pair being coupled to said cold beam by a free end tether and configured to elongate when heated to a greater temperature than a temperature of said cold beam thereby causing the assembly to deflect in a first direction determined by a movement plane. The first beam member and the second beam member of the beam pair are arranged to determine a beam plane such that the beam plane is at an angle $\alpha$ from the movement plane where $\alpha \neq K\pi$ and K is an integer. Various embodiments further relate to microelectromechanical element capable of performing unidirectional in-plane deflection, unidirectional out-of-plane deflection and bi-directional inplane deflection, as well as a latching relay using a combination of a unidirectional out-of-plane element with a bi-directional in-plane element.

FIG. 1

EP 2 168 908 A1

**Description**

**TECHNICAL FIELD OF THE INVENTION**

The present invention generally relates to a microelectromechanical device, also commonly known in the related art as MEMS (microelectromechanical system). Herein the term microelectromechanical device is to be understood to relate to individual microelectromechanical elements, as well as components incorporating such elements such as for example switches or relays.

**BACKGROUND OF THE INVENTION**

Microelectromechanical devices, such as switches or relays, may be used as alternatives for conventional electromechanical devices. Advantages to microelectromechanical devices are programmability and reduced size, enabling smaller form factors and a corresponding reduction in power consumption, response time, and cost. One application that uses conventional microelectromechanical switches, and relays is telecom switching gear.

A known type of microelectromechanical device is the so-called thermal type. The principle of operation of the thermal microelectromechanical devices is based on the use of at least two metallic beams that interact mechanically with each other. In operation, one of the two beams is heated, typically by applying a current to flow through the beam. As a result of such heating, the beam elongates while the other beam which is not heated does not elongate. As the two beams are mechanically engaged, the elongation of the heated beam causes a difference in length between the two beams thus forcing the assembly of the two beams to deflect to a side.

**SUMMERY OF THE INVENTION**

Embodiments of the present invention aim at providing a novel structure of a microelectromechanical device with improved deflection capabilities as compared to the conventional microelectromechanical devices as described herein.

According to embodiments of the inventions, there is provided a microelectromechanical element comprising:

- a cold beam having a free end and a first end connected to a cold beam anchor, said cold beam anchor attached to a substrate;
- a first beam pair comprising a first beam member and a second beam member, the beam pair being coupled to said cold beam by a free end tether and configured to elongate when heated to a greater temperature than a temperature of said cold beam thereby causing the assembly to deflect in a first direction determined by a movement plane;

wherein the first beam member and the second beam member are arranged to determine a beam plane such that the beam plane is at an angle $\alpha$ from the movement plane where $\alpha \neq K\pi$ and K is an integer.

In other embodiments, there is provided a bidirectional microelectromechanical element comprising:

- a cold beam having a free end and a first end connected to a cold beam anchor, said cold beam anchor attached to a substrate;
- a first beam pair comprising a first beam member and a second beam member, the first beam pair being coupled to said cold beam by a free end tether and configured to elongate when heated thereby to a greater temperature than a temperature of said cold beam thereby causing the assembly to deflect in a first direction in a movement plane;
- a second beam pair comprising a third beam member and a fourth beam member, the second beam pair being located on an opposing side of said cold beam from said first beam pair and coupled to said first beam pair and said cold beam by said free end tether, said second beam pair configured to elongate when heated thereby to said greater temperature thereby causing the assembly to deflect in a second direction in said movement plane;

wherein the first beam member and the second beam member are arranged to form a first beam plane and the third beam member and the fourth beam member are arranged to form a second beam plane such that the first beam plane is at an angle $\alpha_1$ from the movement plane and the second beam plane is at an angle $\alpha_2$ from the movement plane where each of $\alpha_1$ and $\alpha_2$ are not equal to $K\pi$, and K is an integer.

In other embodiments, there is provided an in-plane unidirectional microelectromechanical element wherein said movement plane is substantially parallel to a plane determine by a surface of the substrate whereupon said cold beam anchor is attached.

In other embodiments, there is provided an out-of-plane unidirectional microelectromechanical element wherein said movement plane is substantially perpendicular to a plane determined by a surface of the substrate whereupon said cold beam anchor is attached.

In other embodiments, there is provided an in-plane bidirectional microelectromechanical element wherein said movement plane is substantially parallel to a plane determined by a surface of the substrate whereupon said cold beam anchor is attached.

In other embodiments, there is provided a relay using an out-of-plane unidirectional microelectromechanical element and an in-plane bi-directional microelectromechanical element according to the invention.

The foregoing has outlined features of the present invention so that those skilled in the art may better understand the detailed description of the invention that follows. Additional features of the invention will be described hereinafter that form the subject of the claims of the invention. Those skilled in the art should appreciate that they can readily use the disclosed conception and specific embodiment as a basis for designing or modifying other structures for carrying out the same purposes of the present invention. Those skilled in the art should also realize that such equivalent constructions do not depart from the scope of the invention as claimed herein.

## BRIEF DESCRIPTION OF THE DRAWINGS

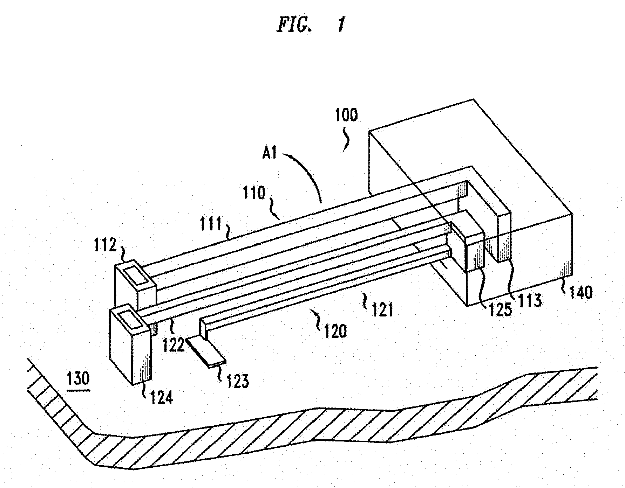

Figure 1 illustrates an exemplary diagram of an embodiment of an in-plane unidirectional microelectromechanical element constructed in accordance with the principles of the present invention.

Figures any 2b are each a partial representation of the in-plane unidirectional microelectromechanical element of figure 1 showing the position of the first beam member and the second beam member with respect to each other and to movement plane, in perspective and in cross-section respectively.

Figure 3 illustrates an exemplary diagram of an embodiment of an in-plane bi-directional microelectromechanical element constructed in accordance with the principles of the present invention.

Figures 4a illustrates an exemplary diagram of an embodiment of an out-of-plane microelectromechanical element constructed in accordance with the principles of the present invention and figure 4b illustrates a head portion of the element of figure 4a in further detail.

Figures 5a, 5b and 5c illustrate various views of an exemplary diagram of an embodiment of a relay using an in-plane bi-directional element and an out-of-play unidirectional element according to the present invention.

## DETAILED DESCRIPTION

Figure 1 schematically illustrates an exemplary diagram of an embodiment of an in-plane unidirectional microelectromechanical element constructed in accordance with the principles of the present invention. The in-plane unidirectional microelectromechanical element 100 comprises a cold beam 110, a first beam pair 120, and a free end tether 140. In some embodiments, the cold beam 110 can have a variable width, *i.e.*, a tapered beam or can have two or more sections with different widths. The cold beam 110 has a body member 111, a first end connected to a cold beam anchor 112 and a free end 113. The free end 113 of the cold beam 110 is attached by conventional means to free end tether 140. The cold beam anchor 112 is attached by conventional means to a substrate, the latter being schematically represented in the figure by reference numeral 130. The cold beam 110 is typically made of a metal such as nickel.

The first beam pair 120 is preferably parallel to the cold beam 110 and is comprised of two preferably parallel members, a first beam member 121 and a second beam member 122, each having a first and second end. The first end of each parallel member is attached to an anchor. The first end of first beam member 121 is attached to a first anchor 123 and the first end of the second beam member 122 is attached to a second anchor 124. First anchor 123 and second anchor 124 are attached to the substrate 130 by conventional means, The second ends of first beam member 121 and second beam member 122 are connected at a connection point 125, to form a closed loop. The connected second ends of first beam member 121 and second beam member 122 are attached to free end tether 140 by conventional means. Both first beam member 121 and second beam member 122 are typically made of a metal such as nickel.

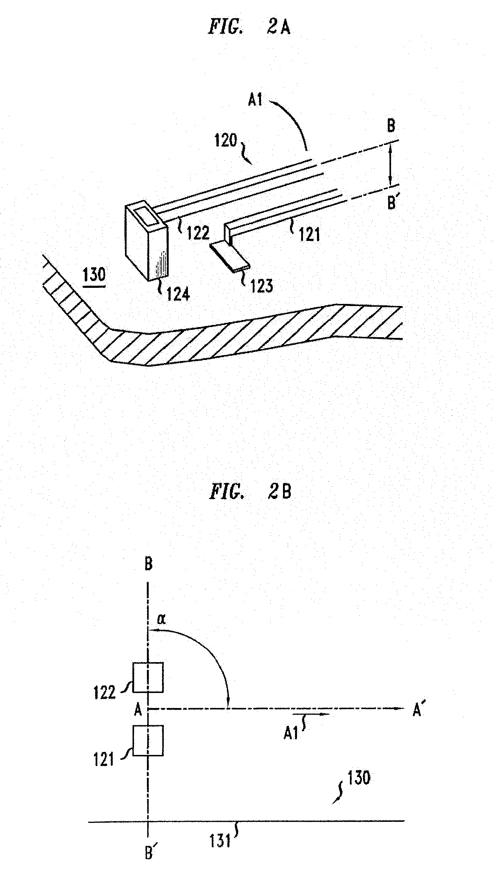

The first beam member 121 and the second beam member 122 are preferably parallel and determine a plane in space as will be described in further detail in relation to figures 2a and 2b. However, it is not mandatory for the first beam member 121 and the second beam member 122 to be parallel. In case the first beam member 121 and the second beam member 122 are not parallel, the plane in space is defined by means of an imaginary line drawn along the lengths of each beam member as will also be described in relation to figures 2a and 2b.

The free end tether 140 mechanically couples: the free end 113 of the cold beam 110; the second ends of first beam member 121 and second beam member 122 of first beam pair 120. The free end tether 140 is typically made of (often entirely made of) a dielectric material. In some embodiments, the dielectric is a photoresist material such as "SU-8." SU-8 is a negative, epoxy-type, near-UV photoresist based on EPON SU-8 epoxy resin (from Shell Chemical). It should be noted that other photoresists can be used as well, depending on design requirements. Other possible suitable materials include polyimide, spin on glass, or other polymers.

The first beam pair 120 is configured to elongate when heated. When the beam pair 120 is heated to a temperature greater than the cold beam 110, the assembly of the in-plane unidirectional microelectromechanical element 100, anchored at one end - through anchors 112, 123 and 124 - to the substrate 130, and mechanically coupled by free end tether 140, will deflect because the beam pair that is heated will elongate greater than the cold beam 110.

In the embodiment shown in Figure 1, when the first beam pair 120 is heated to a temperature greater than a temperature of the cold beam 110, the unidirectional element 100 will deflect in the direction shown by arrow A1.

In this embodiment, the heating of the first beam pair 120 is preferably accomplished by applying current into one beam member of the beam pair and out of the other. For example, current applied into a first beam member 121 of first beam pair 120 and out of a second beam member 122 will cause the first beam pair 120 to heat and elongate and the unidirectional element 100 will deflect in the direction shown by arrow A1 (because: free end tether 140 mechanically couplers cold beam 110 to first beam pair 120; cold beam 110 and first beam pair 120, are anchored to the substrate; and a portion of unidirectional member 100 is located over a trench in the substrate that allows unidirectional element 100 movement parallel to the substrate).

Figure 2a is a partial representation of the in-plane unidirectional microelectromechanical element of Figure 1 in perspective view. In this figure like elements have like reference numerals as those of figure 1. As shown in figure 2a, the first beam pair 120 is partially shown to be anchored on the substrate 130 such that the first beam member 121 is anchored at anchor 123 and the second beam member 121 is anchored at anchor 124. The two beam members 121 and 122 form a plane in space. This plane is schematically represented in figure 2a by means of reference signs B-B'.

On the other hand, as discussed in relation to figure 1, when the first beam pair 120 is heated to a temperature greater than a temperature of the cold beam 110, the unidirectional element 100 will deflect in the direction shown by arrow A1, which is also shown in figure 2a. This movement in the direction of arrow A1 determines a plane in space.

For simplification purposes, the plane determined by the movement of the unidirectional element 100 in the direction of arrow A1 will be herein referred to as movement plane. Likewise, the plane B-B' determined by the two beam members 121 and 122 will be herein referred to as beam plane.

According to embodiments of the invention, the beam plane B-B' is at an angle $\alpha$ from the movement plane determined by arrow A1. This angle is preferably about 90°. However, this is not mandatory and other values for $\alpha$ are also considered within the scope of the present invention as long as $\alpha \neq K\pi$ and K is an integer including zero.

Figure 2b represents the situation between the movement plane and the beam plane. This figure shows a partial view in cross-section of the first and the second beam members 121 and 122 where the beam plane B-B' is schematically represented by a dash-dotted line. Also the movement plane, namely the plane determined by the movement of the unidirectional element 100 in the direction of arrow A1, is represented in figure 2b by means of a dash-dotted line and reference sign A-A'. As can be seen in figure 2b, the movement plane A-A' and the beam plane B-B' are at an angle $\alpha$ with respect to each other.

In terms of geometry, a plane is a two-dimensional imaginary surface whereas the device of the invention is a three-dimensional body. Therefore, there could be an unlimited number of movement planes and beam planes as is described in the following paragraphs.

As regards the movement plane A-A', and assuming for example that the lateral deflection movement of the device 100, when actuated, is in parallel direction with respect to the surface 131 of the substrate 130 (as opposed to deflecting away or towards it), then arrow A1 may be drawn at more or less distance from the surface of the substrate while the direction of the arrow (showing the movement of the element 100 to a side) remains towards the same side and always parallel to the surface 131 of the substrate 130. In other words, more than one arrow A1 may be drawn, however any such arrow will be always pointing towards the same direction of deflection. As a consequence, plane A-A' which is determined by arrow A1 may also be drawn at more or less distance from the surface of the substrate. For example in figure 2b, the movement plane A-A' determined by arrow A1 my be drawn closer or farther with respect to the surface 131 of the substrate 130. This variation in the imaginary position of the plane A-A' does not affect the scope of the invention as all such imaginary planes will be parallel to each other and define the direction of the deflection movement of the device.

The beam plane B-B' is defined by two imaginary parallel lines each drawn along a length of a respective beam member 121 and 122. The length of the beam member 121 is understood to be an imaginary line which extends from one end attached to the anchor 123 to the other end attached to the connection point 125. Likewise, the length of the beam member 122 is understood to be an imaginary line which extends from one end attached to the anchor 124 to the other end attached to the connection point 125. It is to be noted that the above definition of the term "length" is independent from the physical shape of the beam members, which may or may not have the similar shapes and may or may not be parallel. In any of such cases, the lengths (imaginary line) of the beam members as defined above, are parallel to each other.

In this manner the beam plane B-B' is in longitudinal direction with respect to the beam members 121 and 122 as can be observed in figures 2a and 2b. Here also as there may be an unlimited number of imaginary longitudinal planes, the beam plane B-B' may be drawn in a variety of positions. Namely, any plane passing through one imaginary line along the length of beam member 121 and another imaginary line along the length of beam member 122 may be considered as being a beam plane determined by the two beam members 121 and 122 within the scope of the present invention. For example, in figure 2b, the beam plane B-B' is shown to pass through the central longitudinal axes of the beam members 121 and 122 and to be substantially perpendicular to the surface 131 of the substrate 130. This however is only one possibility. Other possibilities may be to draw the beam plane B-B' such that it is not perpendicular, but at an angle other than 90°, to the surface 131 of the substrate 132. The present invention is to be construed as to cover all such imaginary beam planes as long as they pass through two imaginary parallel lines each drawn along the length (imaginary line) of a respective beam member 121 and 122 as described above.

Referring now to the position of the movement plane A-A' with respect to the beam plane B-B' and by reference to figures 2a and 2b, it is appreciated that the beam plane B-B' is at an angle α from the movement plane A-A'. According to embodiments of the invention the value of α satisfies the following relationship

$$\alpha \neq K\pi$$

where K is a positive or negative integer.

This particular structure of the first beam pair 120 requires, when the element is activated, that the direction of deflection of the element 100 (direction of arrow A') be always different from the beam plane B-B'. This structure is advantageous as described below.

In conventional devices, the two beam members define a plane which is parallel to the direction of deflection of the element. For example, the two beam members are structured and mounted such that they are parallel to the surface of the substrate. Further, the beam pair is engaged to a cold beam in such a way that when actuated, the overall element deflects to a side also in a direction parallel to the surface of the substrate. This structure suffers from the drawback that the deflection movement faces certain resistance caused by the structure of the beam pair due to the fact that the two beams members are in the same plane as the plane in which are deflected. As it is known, the beam members are metallic and metals typically present certain rigidity to deformation.

The inventors realized that such stiffness is reduced if the structure of the beam pair is made such that the beam members determine a plane which is not parallel to, or is not the same as, the plane determined by the direction of the deflection movement.

Generally speaking, all structures have a given stiffness (when an external force F is applied, the structure displaces a distance x, within an elastic limit F=K.x, where K is the stiffness factor). The stiffness factor of beams typically depends on various parameters such as intrinsic properties of the material (Young's modulus) and geometric parameters, such as the width, the length and the thickness of the beams, as well as on the distance between beams. A larger width and distance between the beams gives rise to an increase in stiffness of the structure while a larger length of a beam causes a decrease in the stiffness.

In the embodiments of the present invention, the proposed structure allows to reduce the overall width of the device and a reduced width gives rise to a decrease in stiffness.

The advantage of this structure is that the stiffness of the metallic beam members to deformation as well as the overall size of the device are reduced as compared to the conventional structure. Another advantage is that in case it is preferred to reduce the size than the stiffness, the length of the device may be reduced, without substantially reducing the stiffness, thus allowing for a smaller size of the structure.

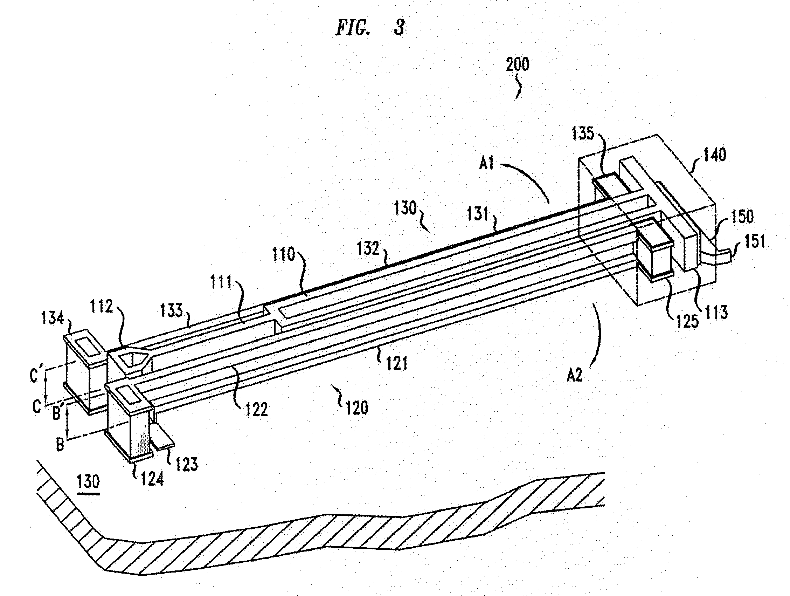

Figure 3 schematically illustrates an exemplary diagram of an embodiment of an in-plane bi-directional microelectromechanical element constructed in accordance with the principles of the present invention. In this figure, like elements have like reference numerals as in figures 1 and 2.

The in-plane bi-directional microelectromechanical element 200 comprises a cold beam 110, a first beam pair 120, a second beam pair 130, and a free end tether 140. The second beam pair 130 is located on an opposing side of the cold beam 110 from the first beam pair.

In some embodiments, the cold beam 110 can have a variable width, *i.e.*, a tapered beam or can have two or more sections with different widths. The cold beam 110 has a body member 111, a first end connected to a cold beam anchor 112 and a free end 113. The free end 113 of the cold beam 110 is attached by conventional means to free end tether 140. The cold beam anchor 112 is attached by conventional means to a substrate, the latter being schematically represented in the figure by reference numeral 130. The cold beam 110 is typically made of a metal such as nickel.

The first beam pair 120 is preferably parallel to the cold beam 110 and is located at a side of the cold beam as shown in figure 3. The beam pair 120 is comprised of two preferably parallel members, a first beam member 121 and a second beam member 122, each having a first and second end. The first end of each parallel member is attached to an anchor. The first end of first beam member 121 is attached to a first anchor 123 and the first end of the second beam member 122 is attached to a second anchor 124. First anchor 123 and second anchor 124 are attached to the substrate 130 by conventional means. The second ends of first beam member 121 and second beam member 122 are connected at a connection point 125, to form a closed loop. The connected second ends of first beam member 121 and second beam member 122 are attached to free end tether 140 by conventional means. Both first beam member 121 and second beam member 122 are typically made of a metal such as nickel.

The first beam member 121 and the second beam member 122 are preferably parallel.

The second beam pair 130 is preferably parallel to the cold beam 110 and is located at a side of the cold beam opposite to that of the first beam pair 120 from the clod beam 110 as shown in figure 3. The second beam pair 130 is comprised of two preferably parallel members, a third beam member 131 and a fourth beam member 132, each having a first and second end. The first end of each parallel member is attached to an anchor. The first end of third beam member 131 is attached to a third anchor 133 and the first end of the fourth beam member 132 is attached to a fourth anchor 134. Third anchor 133 and fourth anchor 134 are attached to the substrate by conventional means. The second ends of third beam member 131 and fourth beam member 132 are connected at a connection point 135, to form a closed loop. The connected second ends of third beam member 131 and fourth beam member 132 are conventionally attached to free end tether 140. Both third beam member 131 and fourth beam member 132 are typically made of a metal such as nickel. In other embodiments, beam pairs may not be parallel to a cold beam or to each other. Additionally, in other embodiments, beam members may have a variable width, *i.e.*, a tapered beam member, may have two or more sections of different widths, or may have a different shape/configuration.

The third beam member 131 and the fourth beam member 132 are preferably parallel.

The free end tether 140 mechanically couples: the free end 113 of the cold beam 110; the second ends of first beam member 121 and second beam member 122, at connection point 125, of first beam pair 120; and the second ends of third beam member 131 and fourth beam member 132 of second beam pair 130, at connection point 135. The free end tether 140 is typically made of (often entirely made of) a dielectric material. In some embodiments, the dielectric is a photoresist material such as "SU-8." If SU-8 is a negative, epoxy-type, near-UV photoresist based on EPON SU-8 epoxy resin (from Shell Chemical). It should be noted that other photoresists can be used as well, depending on design requirements. Other possible suitable materials include polyimide, spin on glass, or other polymers. Moreover, combining different materials is also possible. Providing the free end tether 140 over the cold beam 110 and first and second beam pairs 120 and 130, respectively, is advantageous because it allows use of the above-mentioned materials, which in return provide more flexibility on the tether material and a greater reliability.

Both the first beam pair 120 and second beam pair 130 may have a strain relief at the first end of one of the first 121, second 122, third 131, or fourth 132 beam members. The strain reliefs decrease the stiffness of the first beam pair 120 and second beam pair 130. Of course, other configurations including a strain relief are possible. In some embodiments, a strain relief may be located or shaped differently or not be used.

The first beam pair 120 is configured to elongate when heated. The manner of elongating of the first beam pair of the exemplary embodiment of figure 3 is similar to that of the exemplary embodiment of figures 1 and 2. Therefore, further description in this respect is considered not necessary.

Likewise, the second beam pair 130 is configured to elongate when heated. The manner of elongating of the second beam pair of the exemplary embodiment of figure 3 is similar to that of the exemplary embodiment of figures 1 and 2. Therefore, no further description in this respect is considered not necessary.

In the embodiment shown in Figure 3, when the first beam pair 120 is heated to a temperature greater than a temperature of the cold beam 110 and second beam pair 130, the bi-directional element 200 will deflect in the direction shown by arrow A1. Conversely, when second beam pair 130 is heated to a greater temperature than the cold beam 110 and first beam pair 120, the bi-directional element 200 will deflect in the direction shown by arrow A2.

In this embodiment also, the heating of a beam pair is accomplished by applying current into one beam member of the beam pair and out of the other. For example, current applied into a first beam member of first beam pair 120 and out of a second beam member will cause the first beam pair 120 to heat and elongate and the bi-directional element 200 will deflect in the direction shown by arrow A1 (because: free end tether 140 mechanically couples cold beam 110, first beam pair 120, and second beam pair 130; cold beam 110, first beam pair 120, and second beam pair 130 are anchored to the substrate; and a portion of bi-directional element 200 is located over a trench in the substrate that allows bi-directional element 200 movement parallel to the substrate).

Therefore, the bi-directional microelectromechanical element 200 is capable of deflecting either to one side as shown by arrow A1 or to an opposing side as shown by arrow A2. In this embodiment, the deflection movements in the direction of arrows A1 and A2 are each substantially parallel to the surface of the substrate 130. Therefore, it may be concluded that arrow A1 defines a movement plane which is the same movement plane as defined by arrow A2. The manner of defining the movement planes with respect to arrows A1 and A2 in this embodiment is similar as that described in relation to arrow A1 in the embodiment of figures 1 and 2.

The first beam member 121 and the second beam member 122 of the first beam pair 120 form a first beam plane B-B1.

Likewise, the third beam pair 131 and the fourth beam pair 132 of the second beam pair 130 form a second beam plane C-C'.

The manner the first and the second beam planes are determined is similar to that described with respect to the beam plane B-B' of figures 1 and 2. Therefore, further description in this respect is considered not necessary.

As it may be observed in figure 3, when the first beam pair 120 is heated, the element 200 performs a deflection movement according to arrow A1 (in the movement plane A-A'); likewise when the second beam pair 130 is heated, the element 200 performs a deflection movement according to arrow A2 (in the movement plane A-A'). As a consequence, the first beam plane B-B' is at an angle $\alpha_1$ (not shown) from the movement plane A-A' ; and the second beam plane C-C' is at an angle $\alpha_2$ (not shown) from the movement plane A-A'. Each of these angles is preferably about 90° However, this is not mandatory and other values for $\alpha_1$ and $\alpha_2$ are also considered within the scope of the present invention as long as these angles $\alpha_1$ or $\alpha_2$ are not equal to $K\pi$ where K is an integer.

The bi-directional microelectromechanical element 200 as described above, is therefore capable of deflecting in a direction which is different from the plane determined by the structure of the beam members and therefore has the advantage of reducing the resistance to the deflection movements caused the rigidity of the metallic beam members as already described above in relation to the embodiment of figures 1 and 2.

Attached to the free end 114 of the cold beam is a tip 150. Tip 150 is typically made of a conductive metal such as gold and is attached to the free end 113 of the cold beam 110 with conventional techniques. The tip 150, as illustrated in the embodiment of Figure 3, has a single prong 151. In other embodiments, there could be more than one prong 151 at the end of the tip 150.

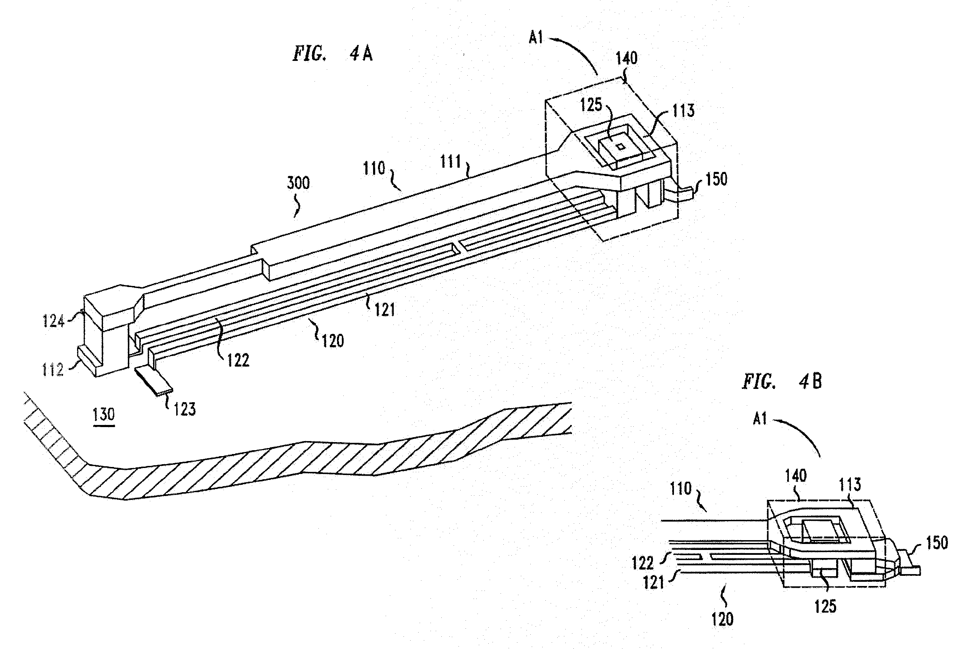

Figure 4a shows an exemplary embodiment of an out-of-plane unidirectional microelectromechanical element 300. In this figure, like elements have like reference numerals as in figures 1 and 2.

The out-of-plane unidirectional microelectromechanical element 300 comprises a cold beam 110, a first beam pair 120, and a free end tether 140. In some embodiments, the cold beam 110 can have a variable width, *i.e.*, a tapered beam or can have two or more sections with different widths. The cold beam 110 has a body member 111, a first end connected to a cold beam anchor 112 and a free end 113. The free end 113 of the cold beam 110 is attached by conventional means to free end tether 140. The cold beam anchor 112 is attached by conventional means to a substrate, schematically represented in the figure by reference numeral 130. The cold beam 110 is typically made of a metal such as nickel.

The first beam pair 120 is parallel to the cold beam 110 and is located in a position underneath the cold beam 100 as shown in figure 4a. The beam pair 120 is comprised of two preferably parallel members, a first beam member 121 and a second beam member 122, each having a first and second end. The first end of each parallel member is attached to an anchor. The first end of first beam member 121 is attached to a first anchor 123 and the first end of the second beam member 122 is attached to a second anchor 124. First anchor 123 and second anchor 124 are attached to the substrate 130 by conventional means. The second ends of first beam member 121 and second beam member 122 are connected at a connection point 125, to form a closed loop. The connected second ends of first beam member 121 and second beam member 122 are attached to free end tether 140 by conventional means. Both first beam member 121 and second beam member 122 are typically made of a metal such as nickel.

The first beam member 121 and the second beam member 122 are preferably parallel. In this embodiment however, the position of the first beam member 121 and the second beam member 122 with respect to each other is such that when not in use, they are substantially in parallel orientation with respect to the surface of the substrate.

The free end tether 140 mechanically couples: the free end 113 of the cold beam 110; the second ends of first beam member 121 and second beam member 122 of first beam pair 120. The free end tether 140 is typically made of (often entirely made of) a dielectric material. In some embodiments, the dielectric is a photoresist material such as "SU-8." SU-8 is a negative, epoxy-type, near-UV photoresist based on EPON SU-8 epoxy resin (from Shell Chemical). It should be noted that other photoresists can be used as well, depending on design requirements. Other possible suitable materials include polyimide, spin on glass, or other polymers.

The first beam pair 120 is configured to elongate when heated. When the beam pair 120 is heated to a temperature greater than the cold beam 110, the assembly of the out-of-plane unidirectional microelectromechanical element 300, anchored at one ends - through anchors 112, 123 and 124 - to the substrate 130, and mechanically coupled at the other end by free end tether 140, will deflect because the beam pair 120 that is heated will expand greater than the cold beam 110.

In the embodiment shown in Figure 4a (and figure 4b), when the first beam pair 120 is heated to a temperature greater than a temperature of the cold beam 110, the unidirectional element 100 will deflect in the direction shown by arrow A1, namely the free end of the element 300 will move away from the substrate 130 (upward in figures 4a and 4b). This deflection direction is obtained due to the special coupling structure between the beam pair 120 and the cold beam 110 at their respective free ends 125 and 113. Figure 4b, illustrates this special structure. As shown in this figure, the connection point 125, coupling the free ends of the first and second beam members 121 and 122, is also coupled to the free end 113 of the cold beam 110 by means of tether 140. When the beam pair is heated it elongates and as the beam pair 120 is located underneath the cold beam 110 and coupled to it at their free ends, the effect of elongation of the beam pair 120 forces the assembly of the two beams 110 and 120 to move up at the free end of the assembly (free end 113 of the cold beam, free end 125 of the beam pair and the tether 140 all attached together). The direction of the movement is shown by means of arrow A1. This arrangement therefore provides a unidirectional out-of-plane microelectromechanical elements.

Referring now to the position of the movement plane (not shown) with respect to the beam plane (not shown), those skilled in the related are will realize that here also, in a similar manner as described with reference to figures 1 and 2, the beam plane is at an angle at from the movement plane. Accordingly the value of $\alpha$ satisfies the following relationship

$$\alpha \neq K\pi$$

where K is a positive or negative integer.

In the embodiment illustrated in Figures 4a and 4b, the heating of the first beam pair 120 is preferably accomplished by applying current into one beam member of the beam pair and out of the other. For example, current applied into a first beam member 121 of first beam pair 120 and out of a second beam member 122 will cause the first beam pair 120 to heat and elongate and the unidirectional element 100 will deflect as discussed above.

Attached to the free end 114 of the cold beam is a tip 150. Tip 150 is typically made of a conductive metal such as gold and is attached to the free end 113 of the cold beam 110 with conventional technique. The tip 150, as illustrated in the embodiment of Figure 3, has a single prong 151. In other embodiments, there could be more than one prong 151 at the end of the tip 150.

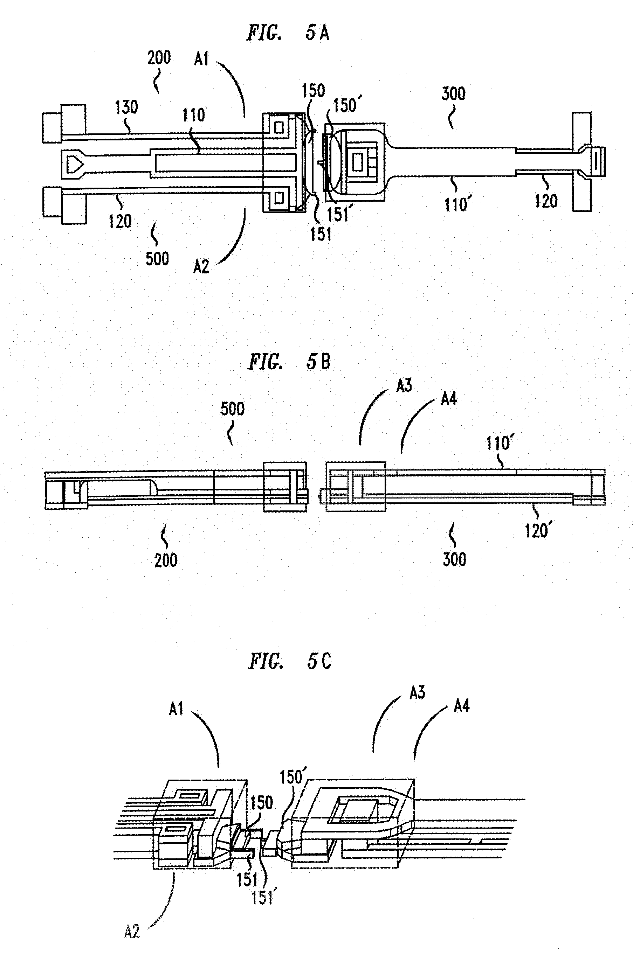

Figures 5a and 5b, 5c illustrate an embodiment of a latching relay configuration made by combining a unidirectional out-of-plane microelectromechanical element with a bi-directional in-plane element both contracted according to embodiments of the present invention. One example of such unidirectional out-of-plane microelectromechanical element may be the embodiment of figures 4a and 4b and one example of a bi-directional in-plane element may be the embodiment of figure 3. As both the unidirectional out-of-plane microelectromechanical element and the bi-directional in-plane element have already been described in detail above, further description of their respective structures is considered not necessary.

Figure 5a is a top view of the unidirectional out-of-plane microelectromechanical element 300 in a no-contact position with respect to the bi-directional in-plane element 200. Figure 5b is a side view of the two elements 200 and 300 in a no-contact position with respect to each other and figure 5c is a partial perspective view of the free ends of the two elements 200 and 300 in a no-contact position with respect to each other.

The latching relay 500 of figures 5a, 5b and 5c is configured to produce electrical contact at least in the following manner.

When a current is applied to the beam pair 120' of the unidirectional element 300, the latter is forced to move away from its initial position as shown by means of arrow A3 in figure 5b. In this manner the unidirectional element moves away from the bi-directional element 200. Next a current is applied to either one of the beam pairs 120 or 130 of the bi-directional element 200. If current is applied to the first beam pair 120, the bi-directional element 200 is made to deflect in the direction shown by arrow A1. Conversely, if current is applied to the second beam pair 130, the bi-directional element 200 is made to deflect in the direction shown by arrow A2.

At a next step, current is removed from the unidirectional element 300 thus making the element 300 to move back to its initial position. This movement to the initial position of the element 300 is shown by means of arrow A4.

Next current is removed from the bi-directional element 200 thus making the element 200 to attempt to move back toward its initial position. However, a prong 151'of a tip of the unidirectional element 150' prevents the bi-directional element 200 from returning to its initial position by contacting a prong 151 of a tip 150 of the bi-directional element 200. The prong 151 of the bi-directional element 200, which was displaced when the current was applied, contacts the prong 151' of the unidirectional element 300 which prevents the bi-directional element 200 from returning to is initial position. In this position, the bi-directional element 200 is deformed and an electrical contact is made between the unidirectional element 300 and the bi-directional element 200. The prong 151', tip 150', and cold beam 110' of the unidirectional element 300 are electrically conductive and in contact with the horizontally displaced and electrically conductive prong 151, tip 150, and cold beam 110 of the bi-directional element 200. In this position, a conductive path is formed that can carry an electrical signal through the microelectromechanical relay 500.

The order of the steps described above may not be the only possibility of operating the relay 500. Other steps may also be performed on the device. For example, in case it is desired to break the electrical contact already established between the respective prongs of the respective microelectromechanical elements 200 and 300, the bi-directional microelectromechanical element 200 may be actuated to be deflected to a side, then the unidirectional microelectromechanical element 300 is actuated to be deflected upwards, next the bi-directional microelectromechanical element 200 is de-actuated (by removing electric current from its beam pair 120) thus causing the element 200 to move back to its initial (no-contact) position. Next the unidirectional microelectromechanical element 300 is de-actuated (by removing electric current from its beam pair 120') thus causing the element 200 to move back to its initial (no-contact) position. In this situation, the relay 500 is back to its initial no-contact position.

Although the present invention has been described in detail, those skilled in the art should understand that they can male various charges, substitutions and alterations herein without departing from the spirit and scope of the invention in its broadest form.

**Claims**

1. A microelectromechanical element comprising:

    - a cold beam having a free end and a first end connected to a cold beam anchor, said cold beam anchor attached to a substrate;
    - a first beam pair comprising a first beam member and a second beam member, the beam pair being coupled to said cold beam by a free end tether and configured to elongate when heated to a greater temperature than a temperature of said cold beam thereby causing the assembly to deflect in a first direction determined by a movement plane;

wherein the first beam member and the second beam member are arranged to determine a beam plane such that the beam plane is at an angle $\alpha$ from the movement plane where $\alpha \neq K\pi$ and K is an integer.

2.  An in-plane unidirectional microelectromechanical element as recited in claim 1, wherein said movement plane is substantially parallel to a plane determined by a surface of the substrate whereupon said cold beam anchor is attached.

3.  An out-of-plane unidirectional microelectromechanical element as recited in claim 1, wherein said movement plane is substantially perpendicular to a plane determined by a surface of the substrate whereupon said cold beam anchor is attached.

4.  A bi-directional microelectromechanical element comprising:

  - a cold beam having a free end and a first end connected to a cold beam anchor, said cold beam anchor attached to a substrate;
  - a first beam pair comprising a first beam member and a second beam member, the first beam pair being coupled to said cold beam by a free end tether and configured to elongate when heated thereby to a greater temperature than a temperature of said cold beam thereby causing the assembly to deflect in a first direction in a movement plane;
  - a second beam pair comprising a third beam member and a fourth beam member, the second beam pair being located on an opposing side of said cold beam from said first beam pair and coupled to said first beam pair and said cold beam by said free end tether, said second beam pair configured to elongate when heated thereby to said greater temperature thereby causing the assembly to deflect in a second direction in said movement plane;

wherein the first beam member and the second beam member are arranged to form a first beam plane and the third beam member and the fourth beam member are arranged to form a second beam plane such that the first beam plane is at an angle $\alpha_1$ from the movement plane and the second beam plane is at an angle $\alpha_2$ from the movement plane where each of $\alpha_1$ and $\alpha_2$ are not equal to $K\pi$, and K is an integer.

5.  An in-plane bi-directional microelectromechanical element as recited in claim 4, wherein said movement plane is substantially parallel to a plane determined by a surface of the substrate whereupon said cold beam anchor is attached.

6.  A microelectromechanical relay using an out-of-plane unidirectional microelectromechanical element as recited in claim 3, and an in-plane bi-directional microelectromechanical element as recited in claim 4.

FIG. 1

FIG. 2A

FIG. 2B

FIG. 3

FIG. 4A

FIG. 4B

FIG.  5 A

FIG.  5 B

FIG.  5 C

**EUROPEAN SEARCH REPORT**

Application Number

EP 08 30 5626

Europäisches Patentamt
European Patent Office
Office européen des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DAVID GIRBAU ET AL: "A Low-Power-Consumption Out-of-Plane Electrothermal Actuator" JOURNAL OF MICROELECTROMECHANICAL SYSTEMS, IEEE SERVICE CENTER, PISCATAWAY, NJ, US, vol. 16, no. 3, 1 June 2007 (2007-06-01), pages 719-727, XP011187745 ISSN: 1057-7157 | 1,3,4 | INV. B81B3/00 |
| A | * paragraph "II. VBB ACTUATOR" * * figure 1 * | 2,5,6 | |
| X | WO 02/23565 A (3M INNOVATIVE PROPERTIES CO [US]) 21 March 2002 (2002-03-21) * page 7, line 1 - line 21 * * page 8, line 1 - line 12 * * page 11, line 23 - page 12, line 12 * * figures 3,4,6,12-14 * | 1 | |
| A | US 2003/002133 A1 (HANSON HEATHER SHANNON [US] ET AL) 2 January 2003 (2003-01-02) * paragraphs [0020], [0023], [0024] * * figures 2-4 * | 1-6 | |

TECHNICAL FIELDS SEARCHED (IPC)

B81B

The present search report has been drawn up for all claims

| Place of search | Date of completion of the search | Examiner |
|---|---|---|
| Berlin | 30 April 2009 | Foussier, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 08 30 5626

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2009

| Patent document cited in search report | | Publication date | Patent family member(s) | | Publication date |
|---|---|---|---|---|---|
| WO 0223565 | A | 21-03-2002 | AU | 8343401 A | 26-03-2002 |
| | | | CA | 2422040 A1 | 21-03-2002 |
| | | | EP | 1346383 A2 | 24-09-2003 |
| | | | JP | 2004509368 T | 25-03-2004 |
| | | | TW | 502003 B | 11-09-2002 |
| | | | US | 2003038703 A1 | 27-02-2003 |
| | | | US | 6483419 B1 | 19-11-2002 |
| US 2003002133 | A1 | 02-01-2003 | NONE | | |

EPO FORM P0459

For more details about this annex : see Official Journal of the European Patent Office, No. 12/82